# EUROPEAN PATENT SPECIFICATION

(11) **EP 1 710 623 B1**
(45) Date of publication and mention of the grant of the patent: **23.07.2008**
(21) Application number: 05007820.3
(22) Date of filing: 08.04.2005
(51) Int. Cl.: G03F 1/00, G03F 7/20

(54) **Method of cleaning a substrate surface from a crystal nucleus**
Methode um eine Substratoberfläche von Kristallisationskeimen zu reinigen
Procédé de nettoyage d'une surface de substrat pour éliminer des germes de cristallisation

(43) Date of publication of application: 11.10.2006
(73) Proprietor: Advanced Mask Technology Center GmbH & Co. KG, 01109 Dresden (DE)
(72) Inventor: Chovino, Christian, Dr., 01309 Dresden (DE)
(74) Representative: Müller - Hoffmann & Partner

(56) References cited:
- JOHNSTONE ERIC V. ET AL: "193-nm haze contamination: a close relationship between mask and its environment" PROCEEDINGS OF THE SPIE, SPIE, BELLINGHAM, VA, US, vol. 5256, 9 September 2003 (2003-09-09), pages 440-448, XP002338364 ISSN: 0277-786X
- ISHII H ET AL: "Root cause analysis for crystal growth at ArF excimer laser lithography" PROCEEDINGS OF THE SPIE - THE INTERNATIONAL SOCIETY FOR OPTICAL ENGINEERING SPIE-INT. SOC. OPT. ENG USA, vol. 5446, no. 1, 2004, pages 218-224, XP002338365 ISSN: 0277-786X
- ESCHBACH F ET AL: "ArF lithography reticle crystal growth contributing factors" PROCEEDINGS OF THE SPIE, SPIE, BELLINGHAM, VA, US, vol. 5567, 14 September 2004 (2004-09-14), pages 497-505, XP002338366 ISSN: 0277-786X

## Description

The present invention relates to a method of cleaning a substrate surface from a crystal nucleus. In particular, the present invention refers to a method of cleaning a surface of a photomask which is commonly used for photolithographically patterning surfaces in the field of semiconductor technologies.

During the manufacture of a semiconductor device, components of the device usually are formed by patterning layers which are deposited on a silicon wafer. The patterning of these layers usually is accomplished by applying a resist material onto the layer which has to be patterned, and by subsequently exposing predetermined portions of the resist layer which is sensitive to the exposure wavelength. Thereafter, the regions which have been irradiated with the radiation (or not) are developed and the irradiated or radiated portions are subsequently removed. As a consequence, portions of the layer are masked by the generated photoresist pattern during a following process step, such as an etching step or an implantation step. After processing the exposed portions of the underlying layer, the resist mask is removed.

For patterning the resist layer, usually photolithographical masks (photomasks) or reticles are used for transferring a predetermined pattern onto the layer which is to be patterned. For example, a photomask, which can be used for optical lithography, comprises a substrate made of a transparent material such as quartz glass, as well as a patterned layer which can be made of an opaque material, for example, a metal such as chromium. Alternatively, the patterned layer can be made of a phase-shifting semitransparent material such as MoSiON (molybdene silioxinitride). In other known photomasks the quartz substrate itself is patterned so as to provide a phase-shifting mask. In addition, part of the quartz substrate can be covered with a pattern made of a phase shifting layer. The patterned material results in a modulation of the intensity of the transmitted light.

In present technologies, patterns are transferred or imaged from the mask to the wafer by means of UV-lithography, wherein an exposure wavelength of 193 nm is commonly used. Although such an exposure is usually conducted in a clean room atmosphere, in which most of the reactant gases are removed by special filters, reactions occur on the surface of the reticle, leading to an unwanted crystal growth. In particular, photoinduced reactions of contaminants, which are present on the photomask surface, with environmental impurities lead to a crystal growth and haze on the surface of the photomask or reticle. To be more specific, the contaminants present on the photomask act as crystal seeds or crystal nuclei from which crystals grow.

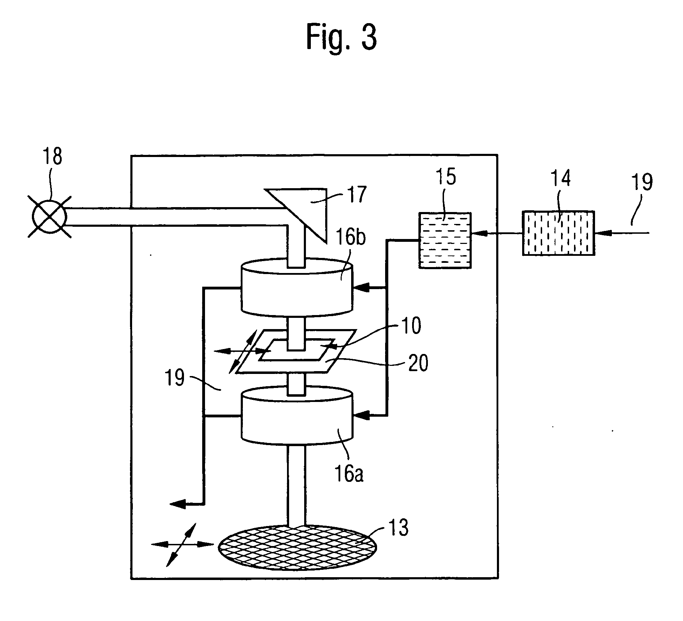

Figure 3 shows an exemplary exposure tool in which a pattern is transferred from a reticle 10 to a wafer 13 by irradiating the reticle with light from a light source 18 which can in particular be an excimer laser emitting a wavelength of 193 nm. The light from the exposure source 18 is directed onto the reticle 10 via the deflecting element (mirror) 17 and the first lens system 16b acting as a collimator. The pattern on the reticle is imaged onto the wafer by means of the second lens system 16a acting as a projection objective. The reticle 10 is held by a stage 20. The two lens systems 16a, 16b and the reticle 10 are purged with purge air 19 which can for example be a mixture of air and nitrogen, the mixture being filtered by a primary filter 14 so as to remove amines or NHx groups from the purge air. In addition, a secondary filter 15 so as to remove the SOₓ groups from the purge air, and, optionally, additional filters such as a carbon filter or a filter for filtering other materials can be provided.

As is known, in particular SOₓ and NHₓ groups cause unwanted crystal growth. Although the concentrations of these contaminants are very low, for example less than 0,1 ppb for SOₓ and less than 0,5 ppb for NHₓ, crystal growth and haze are caused in these exposure tool environments. For example, ammonium sulfate (NH₄)₂SO₄ and ammonium nitrate NH₄NO₃ crystals grow on the reticle surface.

In order to get rid of the unwanted crystals and haze, after several exposure steps, the mask is cleaned in hot water, and, additionally, in liquids such as liquid ammonia, so as to remove the top thin film which is susceptible to crystal growth. Thereby, the reticle surface is cleaned.

This method is disadvantageous, since the optical properties of the reticle may be altered. In addition, crystal growth will again occur, especially since due to the use of special chemicals, such as sulfuric acid, new crystal nuclei are introduced on the reticle surface. Accordingly, after some time this method has to be repeated, thus being time-consuming.

Generally, it is known to clean the reticle surfaces with a piranha clean (H₂SO₄/H₂O₂). In addition, it is known to clean the reticle surfaces with an NH₄OH or SC1(NH₄OH +H₂O₂) chemistry.

Another approach is based on the usage of UV-light which is adapted to decompose the reacting species on the reticle surface.

The reason for the crystal growth to occur is not entirely understood. In particular, it has been observed, that the crystal growth takes place in a certain clean room environment, whereas it does not take place in other clean room environments.

"Improving photomask surface properties through a combination of dry and wet cleaning steps" by Florence Eschbach et al., Proceeding of SPIE, vol 5446, 209-217 (2004), discloses experiments on photoinduced crystal growth on photomasks.

In addition, Johnstone Eric V. et al. "193-nm haze contamination: a close relationship between mask and its environment" Proceedings of the SPIE, SPIE, Bellingham, VA, US, vol. 5256, 9 September 2003, discloses investigations on the generation of haze on a photomask.

Moreover, Ishii H. et al. "Root cause analysis for crystal growth at ArF excimer laser lithography" Proceedings of the SPIE - The International Society for Optical Engineering SPIE-Int. Soc. Opt. Eng USA, vol. 5446, No. 1, 2004, pages 218-224 discloses investigations on crystal growth at ArF excimer laser lithography, wherein the dependence of the crystal growth on the exposure environment is analyzed.

In addition, Eschbach F. et al. "ArF lithography reticle crystal growth contributing factors" Proceedings of the SPIE, SPIE, Bellingham, Va. US, Vol. 5567, 14 September 2004, pages 497-505 discloses investigations on crystal growth on photomasks.

Since the usage of thoroughly clean masks is a major task for exactly transferring the pattern from the mask to the wafer, there is a strong demand for obtaining a method of cleaning the surface of a photomask.

In view of the above, it is an object of the present invention to provide a method of cleaning a substrate surface from a crystal nucleus or a crystal seed.

According to the present invention, the above object is achieved by a method of cleaning a substrate surface from a crystal nucleus, comprising the steps of setting conditions which are adapted to cause an accelerated crystal growth from said crystal nucleus, wherein said growth is accelerated with respect to the growth under normal clean room and normal air conditions, said conditions comprising the supply of energy so as to induce a crystal growth, and the feeding of at least one reactive gas at a higher concentration than under normal clean room and normal air conditions, the reactive gas being a gas which is adapted to react with said crystal nucleus, exposing said substrate surface to said set conditions so that a crystal is grown from said crystal nucleus, and removing said grown crystal.

In addition, the present invention provides a method of cleaning the surface of a photomask comprising the steps as defined above.

The present invention provides a method of cleaning a substrate surface from a crystal nucleus in which the substrate surface is held in a condition under which a crystal growth is accelerated with respect to normal clean room and normal air conditions.

As is well known, normal dry air comprises 78,08% N₂, 20,95% O₂, 0,93% Ar and, in addition, trace gases such as CO₂ (0,034 %), H₂ (0,00005 %) and others. In particular, the amount of reactive trace gases is very low. Usually, the air in clean rooms is stabilized with respect to temperature and humidity, and, in addition, is filtered so as to remove small particles. For example, the temperature in a clean room is 23 ± 0,5°C and the relative humidity thereof is 42% ± 3%. Except for the humidity, the composition of clean room air basically is identical with the composition of normal dry air.

According to the present invention, energy so as to induce a crystal growth is supplied to the substrate and, in addition, at least one reactive gas is fed to the substrate at a higher concentration of the specific gas than under normal clean room and normal air conditions so as to cause an accelerated crystal growth. The term "reactive gas" as used herein is referred to a gas which will react with a crystal nucleus on a substrate surface. In particular, it includes any oxidizing or reducing gases, especially gaseous ammonia, oxygen, ozone, hydrogen and water vapour. In particular, even if a certain reactive gas is not present in normal air or normal clean room air, it is clearly to be understood that the feature "at a higher concentration than under normal clean room and normal air conditions" means and comprises any concentration of this reactive gas.

The energy so as to induce a crystal growth can be supplied by irradiating the substrate surface with electromagnetic radiation. Thereby, a photon induced crystal growth is promoted. Alternatively or additionally, the energy can be supplied by directly locally heating the substrate, thus causing a thermally induced crystal growth.

After placing the substrate under these conditions for sufficient time so as to enable a crystal growth, the grown crystals are removed. As a consequence, the crystal nucleus is removed from the substrate surface.

According to a preferred embodiment of the present invention, the electromagnetic radiation which is irradiated on the substrate surface has a wavelength in the UV range, this wavelength being particularly suitable for inducing a crystal growth.

Alternatively or additionally, the substrate surface can for example be irradiated with IR (Infrared) light, having a wavelength greater than 800 nm. Thereby, the substrate surface is heated, whereby a thermally induced crystal growth takes place.

For cleaning a surface of a photomask, it is preferred to irradiate the photomask with light having a wavelength which is in a range of λₑₓ ± 20%, wherein λₑₓ denotes the exposure wavelength. In this case, when performing the cleaning method, similar reactions as during the exposure are caused.

According to the present invention, the conditions can be set by feeding gases which will react with the contaminants left on the substrate surface. Examples of these gases comprise ammonia, oxygen, ozone, hydrogen and water vapour. In addition, preferably a carrier gas such as N₂ or any other inert gas such as Ar or He is introduced. In particular, at the substrate surface the concentration of at least one of the active gases, i.e. the gases which will react with the crystal nucleus, is higher than under normal clean room conditions. To be more specific, a flow rate of 0 - 0,5 1/min of the active gases is especially preferred. Accordingly, at the substrate surface a concentration of the reactive gases of approximately 0,05 to 20 % is especially preferred. In particular, for oxygen having a relatively high concentration in ambient air, a concentration of 21 to 40 % is especially preferred.

In addition, it is advantageous to perform the method of the invention at a reduced pressure. In particular, a pressure of less than 1 atm (1,013 . 10⁵ Pa), more specifically 10 to 10⁴ Pa, is preferred. By reducing the pressure, the atmosphere at the substrate surface can be controlled so that only the reactive gases for well defined chemical reactions with the crystal seeds are present on the substrate surface.

Preferably, the chamber in which the cleaning process takes place, is controlled at a pressure as specified above, and then one or more reactive gases in combination with a carrier gas are fed, so that at the substrate surface a concentration of at least one reactive gas is higher than under normal clean room and normal air conditions.

After the crystals have been grown on the substrate surface, the crystals will be removed. According to the present invention, it is especially preferred to remove the crystals by bringing them into contact with a liquid. In particular, by rinsing with the liquid, most of the crystals will be removed, the remaining crystals dissolving in the liquid. In addition or alternatively, the crystals can be removed from the substrate surface by cleaning the substrate in a megasonic bath.

According to the invention, it is preferred to remove the grown crystal by bringing the substrate surface into contact with an ammonia-free and/or sulfate-free liquid. In this case, an additional contact with the contaminants, i.e. NHₓ and SOₓ groups, which essentially cause unwanted crystal growth can be avoided.

The use of water, especially pure water, preferably containing CO₂, is particularly preferred since thereby no additional contaminant is introduced on the substrate surface.

In particular, if after the step of exposing the substrate surface to the set conditions, the only liquid the substrate is brought into contact with is pure water, additional contaminants can be avoided. This is a major advantage with respect to conventional methods, according to which the substrate is cleaned with NH₄OH and/or H₂SO₄ based chemicals.

In the following, the present invention will be described in greater detail with reference to the accompanying drawings.
- Fig. 1: shows a plan view on a photomask which can be cleaned with the method of the present invention.
- Fig. 2: illustrates an exemplary device for cleaning a substrate surface from a crystal nucleus; and
- Fig. 3: illustrates an exposure chamber for exposing a resist material on a semiconductor substrate.

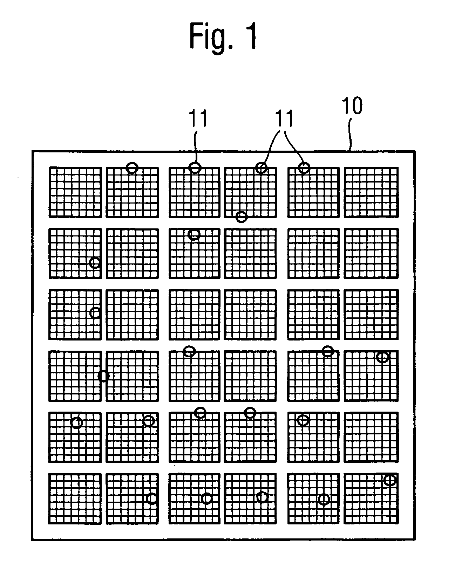

Fig. 1 shows a photolithographic mask 10 which can be used for photolithographically transferring a predetermined pattern onto a photoresist material which is applied on a semiconductor substrate. As can be seen from Fig. 1, usually, the photomask includes a plurality of patterns which are transferred from the mask to the photoresist material by exposing the photoresist material with light which has been transmitted or reflected by this photomask. In addition, a plurality of crystal nuclei or crystal seeds 11 are left on the surface of the photomask.

As is obvious to the person skilled in the art, the method of the present invention can equally be applied to any kind of photomask, including reflective or transmissive photomasks, UV, EUV, VIS or other photomasks which are used in other wavelength regions.

As can be gathered from Fig. 1, the presence of haze or crystal growth on the surface of such a reticle will cause severe problems, since using one mask a plurality of wafers is exposed and, consequently, a much greater plurality of chips is made. If the surface of the mask is contaminated, this large amount of chips will be defective.

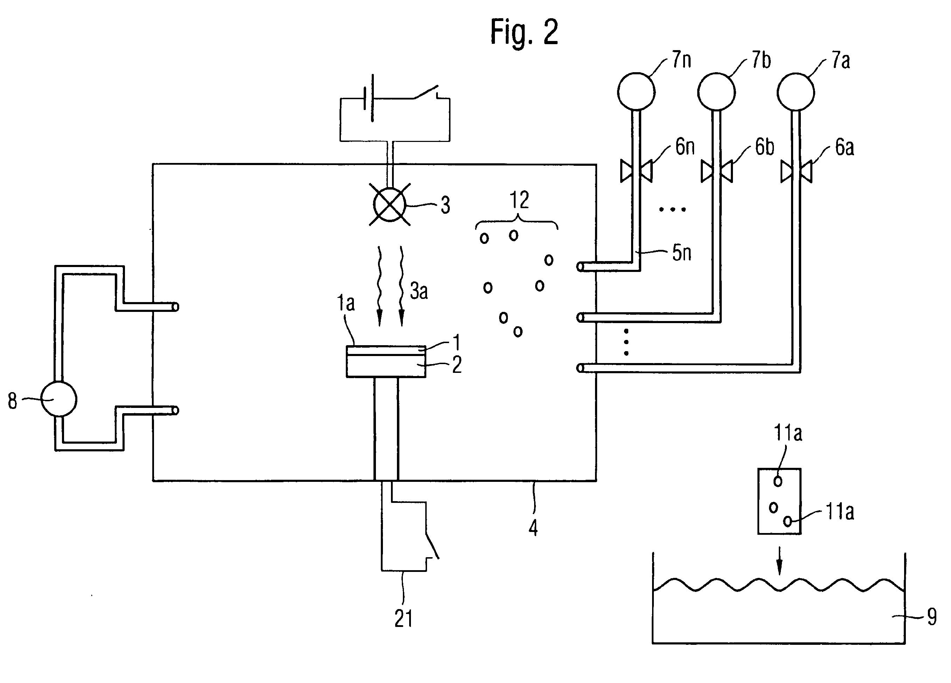

Fig. 2 illustrates a device for cleaning a substrate surface from a crystal nucleus. The substrate 1 is held by a substrate holder 2, the substrate surface 1a being exposed to the atmosphere. A heating device 21 for directly heating the substrate holder can be disposed at the substrate holder 2. The substrate holder 2 is enclosed by a chamber 4, in which a predetermined pressure can be set by means of a pump 8. A plurality of gas cylinders 7a, ..., 7n is provided, and they are connected with the chamber 4 via gas lines 5a, ..., 5n. The gas flow of a specific gas from the cylinder 7a, ..., 7n to the chamber 4 can be controlled by means of the corresponding valve 6a, ..., 6n. The light source 3 is provided so as to irradiate the substrate surface with light of a specific wavelength. In particular, by irradiating the substrate 1 with the light 3a from the light source 3, a reaction of the crystal nucleus 11 with one or more of the gases 12 fed to the chamber 4 will be accelerated or even caused.

For performing the method of the present invention, a substrate 1 is placed on the substrate holder 2. The substrate can in particular be a reticle or a photomask. Nevertheless, it is as well possible, that the substrate is a semiconductor wafer, a quartz substrate or any other substrate which has one or more crystal nuclei 11 on it.

After optionally setting a predetermined pressure, by feeding appropriate gases to the chamber 4, a condition which is nearly similar to the condition of a clean room or an exposure tool, for example, is provided. In particular, an active gas such as oxygen (O₂), ammonia (NH₄), water vapour (H₂O), hydrogen (H₂) is fed solely or in combination to the chamber 4. In particular, the active or reactive gas is fed so that a concentration thereof is higher than in normal air and normal clean room air.

By controlling the valves 6a to 6n, the flow rate of these active gases can be controlled. In particular, a flow rate of more than 0 to 0,5 1/min (0,5 *10³ sccm, cubic centimetres per minute under standard conditions) of the active gases is set. In particular, if three active gases are fed to the chamber 4, the sum of the individual flow rates equals to a maximum of 0,5 1/min.

In addition, a carrier gas is fed to the chamber. As a carrier gas, N₂ or another inert gas such as Argon (Ar), Helium (He) or any other noble gas can be fed solely or in combination. The total flow rate of the carrier gases preferably is more than 0 to 10 1/min. In addition, the UV lamp 3 is caused to irradiate UV radiation. The UV lamp 3 can for example be a Xenon lamp, emitting a wavelength of 172 nm. In particular, it is preferred, that the lamp emits a radiation having a wavelength similar to the exposure wavelength of the specific reticle. For example, the wavelength of the UV lamp can be λex ± 20 %, wherein λex denotes the exposure wavelength.

As an alternative, infrared radiation having an appropriate wavelength so as to heat the substrate, can be irradiated onto the substrate surface. The chamber 4 is held at room temperature of about 22°C and at a varying pressure.

The conditions of the examples of the invention are given in the following table.

| Example No. | Pressure | Reactive Gas | Flow rate | Flow rate of the Carrier Gas |
|---|---|---|---|---|
| 1 | 1 atm (1,013·10⁵ Pa) | Ozone | 0,3 l/min | 7 l/min |
| 2 | 40 Pa | Oxygen | 0,5 l/min | 0,5 l/min |
| 3 | 1000 Pa | Oxygen | 0,5 l/min | 0,5 l/min |
| 4 | 1 atm (1,013·10⁵ Pa) | Oxygen/water vapour | 0,5/0,1 | 10 l/min |
| 5 | 10⁴ Pa | NH₃ | 0,2 l/min | 8 l/min |
| 6 | 100 Pa | Hydrogen | 0,1 l/min | 7 l/min |

The substrate 1 is held in the chamber 4 with the set conditions as described above, for about 10 minutes, so as to induce a crystal growth on the substrate surface. Thereafter, the substrate 1 is taken from the chamber 4 and rinsed with water, for example by holding it into a water bath 9 so as to thoroughly clean the surface from the grown crystals 11a. After drying the substrate surface, the surface is entirely cleaned, with all the crystal nuclei removed from its surface.

Under the conditions as described above, the crystal growth will take place on the substrate surface, thus consuming the residuals and the contaminants, which have originally been present on the surface of the photomask, and which are usually responsible for the crystal growth in the wafer exposure tool. The crystal 11a grown is easily rinsed off the surface. After this process, the mask becomes free of residuals and contaminants which are usually susceptible to crystal growth and haze.

### List of References

- 1: substrate
- 1a: substrate surface
- 2: substrate holder
- 3: UV lamp
- 3a: UV light
- 4: chamber
- 5a: gas line
- 5b: gas line
- 5n: gas line
- 6a: valve
- 6b: valve
- 6n: valve
- 7a: gas cylinder
- 7b: gas cylinder
- 7n: gas cylinder
- 8: pump
- 9: cleaning bath
- 10: reticle
- 11: crystal nucleus
- 11a: crystal
- 12: gas
- 13: wafer
- 14: primary filter
- 15: secondary filter
- 16a: first lens system
- 16b: second lens system
- 17: mirror
- 18: exposure lamp
- 19: purge air
- 20: stage
- 21: heating device

## Claims

1. A method of cleaning a substrate surface (1a) from a crystal nucleus (11), comprising the steps of:
- setting conditions which are adapted to cause an accelerated crystal (11a) growth from said crystal nucleus (11), wherein said growth is accelerated with respect to the growth under normal clean room and normal air conditions, said conditions comprising the supply of energy so as to induce a crystal (11a) growth, and the feeding of at least one reactive gas at a higher concentration than under normal clean room and normal air conditions, the reactive gas being a gas which is adapted to react with said crystal nucleus (11),
- exposing said substrate surface (1a) to said set conditions so that a crystal (11a) is grown from said crystal nucleus (11),
- removing said grown crystal (11a).

2. The method according to claim 1, wherein said supply of energy comprises the irradiation of light (3a).

3. The method according to claim 2, wherein said light (3a) is UV light having a wavelength in a range from 100 to 400 nm.

4. The method according to claim 2, wherein said light (3a) is infrared light having a wavelength of more than 800 nm.

5. The method according to any of claims 1 to 4, wherein said gas (12) is selected from the group consisting of ammonia, water vapour, hydrogen and oxygen.

6. The method according to any of claims 1 to 5, wherein said gas (12) is fed at a predetermined flow rate.

7. The method according to any of claims 1 to 6, wherein additionally an inert gas (12) acting as a carrier gas is fed to said substrate surface (1a).

8. The method according to any of claims 1 to 7, wherein said conditions additionally comprise a pressure which is below 1,013 · 10⁵ Pa.

9. The method according to claim 8, wherein said pressure is 10 to 10⁴ Pa.

10. The method according to any of claims 1 to 9, wherein said grown crystal (11a) is removed by bringing said substrate surface (1a) into contact with a liquid (9).

11. The method according to claim 10, wherein said liquid (9) is an ammonia-free and/or a sulfate-free liquid.

12. The method according to claim 11, wherein said liquid (9) is water.

13. A method of cleaning the surface of a photomask (10) comprising the steps of any of claims 1 to 12.

## Patentansprüche

1. Verfahren zum Reinigen einer Substratoberfläche (1a) von einem Kristallkeim (11), umfassend die Schritte:
- Einstellen von Bedingungen, die ein beschleunigtes Kristallwachstum (11a) ausgehend von dem Kristallkeim (11) veranlassen, wobei das Wachstum im Hinblick auf das Wachstum unter gewöhnlichen Reinraum- und gewöhnlichen Luftbedingungen beschleunigt ist, die Bedingungen die Energiezufuhr zum Einleiten des Kristallwachstums (11a) umfassen, sowie das Zuführen wenigstens eines reaktiven Gases mit im Vergleich zu gewöhnlichen Reinraum- und gewöhnlichen Luftbedingungen höherer Konzentration, wobei das reaktive Gas ein Gas ist, das mit dem Kristallkeim (11) reagiert,
- Aussetzen der Substratoberfläche (1a) den eingestellten Bedingungen, so dass aus dem Kristallkeim (11) ein Kristall (11a) wächst,
- Entfernen des aufgewachsenen Kristalls (11a).

2. Verfahren nach Anspruch 1, wobei die Energiezufuhr die Bestrahlung mit Licht (3a) umfasst.

3. Verfahren nach Anspruch 2, wobei das Licht (3a) ein UV-Licht mit einer Wellenlänge im Bereich von 100 bis 400 nm ist.

4. Verfahren nach Anspruch 2, wobei das Licht (3a) Infrarotlicht mit einer Wellenlänge von mehr als 800 nm ist.

5. Verfahren nach einem der Ansprüche 1 bis 4, wobei das Gas (12) aus der Gruppe bestehend aus Ammoniak, Wasserdampf, Wasserstoff und Sauerstoff ausgewählt ist.

6. Verfahren nach einem der Ansprüche 1 bis 5, wobei das Gas (12) mit vorgegebener Flussrate zugeführt wird.

7. Verfahren nach einem der Ansprüche 1 bis 6, wobei der Substratoberfläche (1a) zusätzlich ein Inertgas (12), das als Trägergas wirkt, zugeführt wird.

8. Verfahren nach einem der Ansprüche 1 bis 7, wobei die Bedingungen zusätzlich einen Druck unterhalb von 1,013 · 10⁵ Pa einschließen.

9. Verfahren nach Anspruch 8, wobei der Druck 10 bis 10⁴ Pa beträgt.

10. Verfahren nach einem der Ansprüche 1 bis 9, wobei der gewachsene Kristall (11a) entfernt wird, indem die Substratoberfläche (1a) in Kontakt mit einer Flüssigkeit (9) gebracht wird.

11. Verfahren nach Anspruch 10, wobei die Flüssigkeit (9) eine Ammoniak-freie und/oder eine Sulfat-freie Flüssigkeit ist.

12. Verfahren nach Anspruch 11, wobei die Flüssigkeit (9) Wasser ist.

13. Verfahren zum Reinigen der Oberfläche einer Fotomaske (10) mit den Schritten gemäß einem der Ansprüche 1 bis 12.

## Revendications

1. Procédé pour enlever par nettoyage un germe (11) de cristal d'une surface (1a) de substrat, comprenant les stades dans lesquels :
- on fixe des conditions qui sont conçues pour provoquer une croissance accélérée du cristal (11a) à partir du germe (11) de cristal, la croissance étant accélérée par rapport à la croissance dans des conditions de salle blanche normales et d'air normales, ces conditions comprenant l'envoi d'une énergie de manière à induire une croissance du cristal (11a) et l'alimentation en au moins un gaz réactif à une concentration plus grande que dans des conditions de salle blanche normales et d'air normales, le gaz réactif étant un gaz qui est conçu pour réagir sur le germe (11) de cristal,
- on expose la surface (10a) du substrat à ces conditions réglées de manière à ce qu'un cristal (11a) croisse à partir du germe (11) de cristal,
- on enlève le cristal (11a) qui a crû.

2. Procédé suivant la revendication 1, dans lequel l'alimentation en énergie comprend une exposition à la lumière (3a).

3. Procédé suivant la revendication 2, dans lequel la lumière (3a) est de la lumière UV ayant une longueur d'onde comprise entre 100 et 400 nm.

4. Procédé suivant la revendication 2, dans lequel la lumière (3a) est de la lumière infrarouge ayant une longueur d'onde supérieure à 800 nm.

5. Procédé suivant l'une quelconque des revendications 1 à 4, dans lequel le gaz (12) est choisi dans le groupe consistant en l'ammoniac, la vapeur d'eau, l'hydrogène et l'oxygène.

6. Procédé suivant l'une quelconque des revendications 1 à 5, dans lequel on envoie le gaz (12) à un débit déterminé à l'avance.

7. Procédé suivant l'une quelconque des revendications 1 à 6, dans lequel on envoie à la surface (1a) du substrat supplémentairement un gaz (12) inerte agissant en tant que gaz porteur.

8. Procédé suivant l'une quelconque des revendications 1 à 7, dans lequel les conditions comprennent supplémentairement une pression qui est inférieure à 1.013 · 10⁵ Pa.

9. Procédé suivant la revendication 8, dans lequel la pression est comprise entre 10 et 10⁴ Pa.

10. Procédé suivant l'une quelconque des revendications 1 à 9, dans lequel on enlève le cristal (11a) qui a crû en mettant la surface (1a) du substrat en contact avec un liquide (9).

11. Procédé suivant la revendication 10, dans lequel le liquide (9) est un liquide exempt d'ammoniac et/ou un liquide exempt de sulfates.

12. Procédé suivant la revendication 11, dans lequel le liquide (9) est l'eau.

13. Procédé de nettoyage de la surface d'un masque (10) photographique comprenant les stades suivant l'une quelconque des revendications 1 à 12.
